# EUROPEAN PATENT APPLICATION

(11) **EP 4 606 929 A1**
(43) Date of publication of application: **27.08.2025**
(21) Application number: 25157773.0
(22) Date of filing: 13.02.2025
(51) Int. Cl.: C23F 1/18, H05K 3/00, H05K 3/06

(54) **ETCHING SOLUTION, REPLENISHMENT SOLUTION, AND METHOD FOR FORMING COPPER WIRING**

(30) Priority: 21.02.2024 JP 2024024813; 09.12.2024 WO PCT/JP2024/043418
(71) Applicant: MEC Company Ltd., Amagasaki-shi, Hyogo 660-0822 (JP)
(72) Inventor: Kumazaki, Kosuke, Hyogo, 6600822 (JP); Hamaguchi, Hitomi, Hyogo, 6600822 (JP); Igami, Kaori, Hyogo, 6600822 (JP)
(74) Representative: dompatent von Kreisler Selting Werner - Partnerschaft von Patent- und Rechtsanwälten mbB

(57) **Abstract**

An object of the present invention is to provide an etching solution, a replenishment solution, and a method for forming a copper wiring, in which an original function of an etching solution such as suppression of side etching is easily maintained.

As a means for solving the problem of the present invention, there is disclosed a copper etching solution, in which the etching solution contains an acid, an oxidizing metal ion, a bromide ion, a compound having a piperazine skeleton, and an imidazole compound, and the compound having a piperazine skeleton is represented by the following general formula (1):

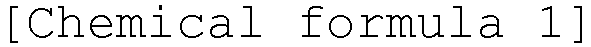

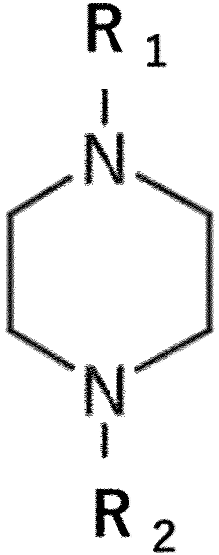

In the formula, R1 and R2 each independently represent a hydrogen atom, an amino group-containing substituent, or a hydrocarbon derivative group having 1 to 10 carbon atoms wherein the hydrocarbon derivative group does not contain an amino group-containing substituent.

## Description

### Technical Field

The present invention relates to an etching solution, a replenishment solution thereof, and a method for forming a copper wiring using the same.

### Background Art

When a copper wiring pattern is formed by a photoetching method in the manufacture of a printed wiring board, an iron chloride-based etching solution, a copper chloride-based etching solution, an alkaline etching solution, or the like is used as an etching solution. When these etching solutions are used, copper under an etching resist may be dissolved from the side surface of the wiring pattern, which is called "side etching". That is, by being covered with an etching resist, a part that is originally desired not to be removed by etching (that is, the copper wiring part) is removed by an etching solution, and a phenomenon has occurred in which the width becomes narrower from the bottom part to the top part of the copper wiring, or the width becomes considerably thinner than the desired width, and a preferable wiring shape cannot be obtained. In particular, when the copper wiring pattern is fine, such side etching should be reduced as much as possible.

Patent Document 1 and Patent Document 2 describe etching solutions for suppressing side etching in which an azole compound, which is a heteroaromatic five-membered ring compound, is blended.

Patent Document 3 and Patent Document 4 describe etching solutions containing a specific aliphatic heterocyclic compound such as piperazine, and describe that side etching can be suppressed by the action of this piperazine without deteriorating the linearity of copper wiring.

However, in the etching solutions of Patent Documents 3 and 4, the specific aliphatic heterocyclic compound is decomposed and reduced as the etching solution is continuously used, and the original functions of the etching solution such as suppression of side etching and maintenance of linearity may not be sufficiently exhibited, and there is a problem that it is difficult to manage the etching solution.

In order to cope with such a problem, Patent Document 3 describes that in order to suppress decomposition of an aliphatic heterocyclic compound, a heteroaromatic compound having a 5-membered heteroaromatic ring is added to an etching solution in advance to attempt to suppress decomposition of the aliphatic heterocyclic compound.

However, there is no description about a combination of an aliphatic heterocyclic compound and a heteroaromatic compound capable of effectively suppressing the decomposition of the aliphatic heterocyclic compound in each document, and an etching solution continuously obtaining a sufficient side etching suppression effect even when continuously used is required.

### PRIOR ART DOCUMENTS

### Patent Documents

Patent Document 1: JP 2005-330572 A
Patent Document 2: JP 2009-79284 A
Patent Document 3: JP 2014-224303 A
Patent Document 4: JP 2017-48409 A

### Summary of Invention

### Technical Problem

The present invention has been made in view of the above-described problems of the prior art, and an object of the present invention is to provide an etching solution that continuously provides a sufficient side etching suppression effect even in continuous use, a replenishment solution therefor, and a method for forming a copper wiring that can continuously provide a sufficient side etching suppression effect.

### Solution to Problem

The copper etching solution according to the present invention contains an acid, an oxidizing metal ion, a bromide ion, a compound having a piperazine skeleton, and an imidazole compound,
the compound having a piperazine skeleton is represented by the following general formula (1).

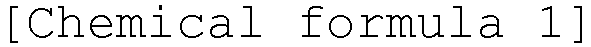

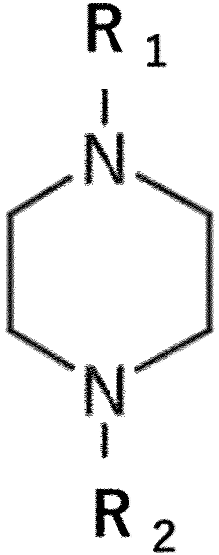

In the formula, R1 and R2 each independently represent a hydrogen atom, an amino group-containing substituent, or a hydrocarbon derivative group having 1 to 10 carbon atoms, wherein the hydrocarbon derivative group does not contain an amino group-containing substituent.

The imidazole compound may be one or more selected from the group consisting of imidazole, 2-ethyl-4-methylimidazole, 1-imidazole acetic acid, 2-ethylimidazole, 2-aminobenzimidazole, 1-(3-aminopropyl)imidazole, and 2-aminoimidazole sulfate.

The imidazole compound may be an imidazole compound having no amino group.

The imidazole compound may be contained in an amount of 0.10 g/L or more and 20 g/L or less.

The compound having a piperazine skeleton may be contained in an amount of 0.01 g/L or more and 100 g/L or less.

The acid may be hydrochloric acid.

The oxidizing metal ion may be a cupric ion.

The concentration of the bromide ion may be 10 g/L or more and 150 g/L or less.

The present invention also relates to a replenishment solution, which is a replenishment solution to be added to the etching solution when the etching solution is continuously or repeatedly used, and includes the compound having a piperazine skeleton and the imidazole compound.

Further, the present invention also relates to a method for forming a copper wiring, which is a method for forming a copper wiring by etching a copper layer not covered with an etching resist, and etching is performed using the etching solution described above.

### Effects of Invention

According to the present invention, it is possible to provide an etching solution that continuously provides a sufficient side etching suppression effect even in continuous use, a replenishment solution therefor, and a method for forming a copper wiring that continuously provides a sufficient side etching suppression effect.

### Brief Description of Drawings

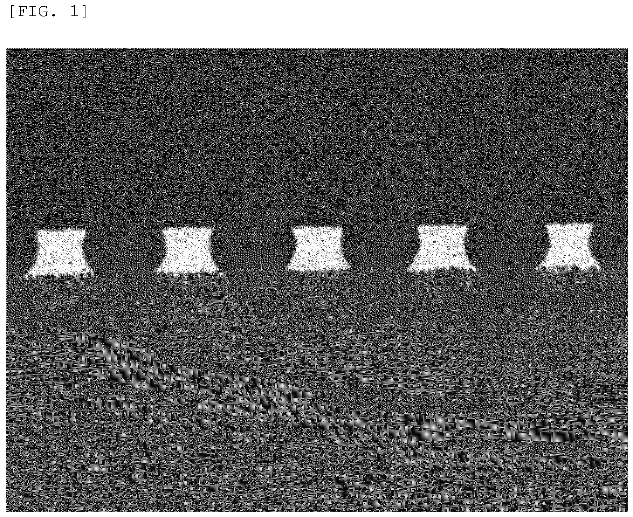

FIG. 1 shows a cross-sectional photograph of a copper wiring etched with an etching solution of the present embodiment.

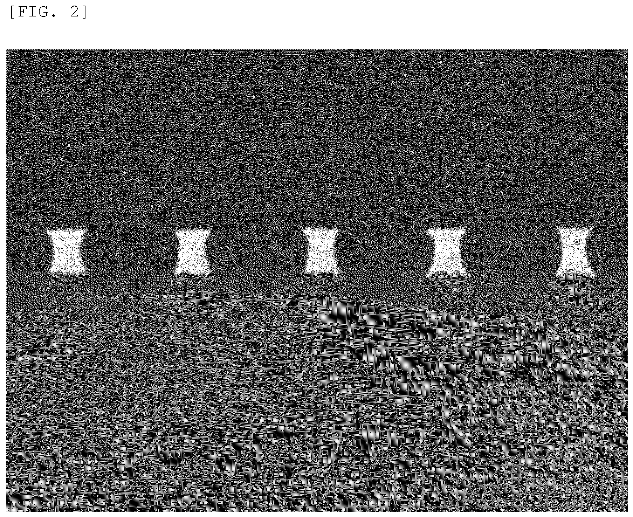

FIG. 2 shows a cross-sectional photograph of a copper wiring etched with an etching solution of the present embodiment.

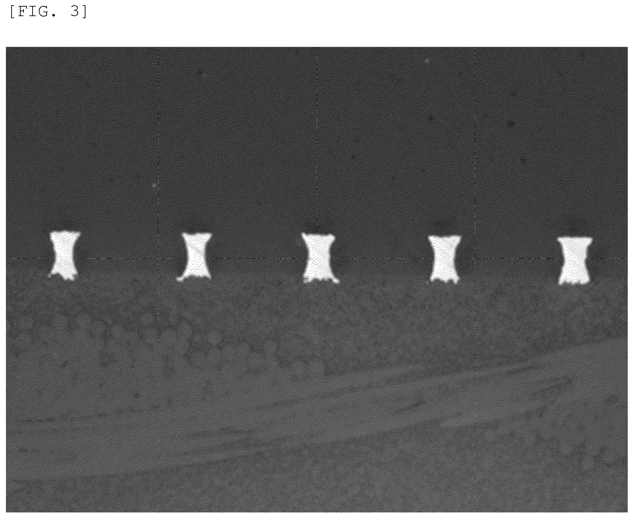

FIG. 3 shows a cross-sectional photograph of a copper wiring etched with an etching solution of a comparative example.

### Description of Embodiments

Hereinafter, embodiments of an etching solution, a replenishment solution therefor, and a method for forming a copper wiring according to the present invention will be described.

First, an etching solution of the present embodiment will be described.

The etching solution of the present embodiment is an etching solution mainly used for forming copper wiring.

That is, the etching solution is an etching solution used for forming a predetermined shape of copper wiring or the like by covering the surface of the copper layer with an insulating layer such as an etching resist and bringing the etching solution into contact with a part not covered with the insulating layer.

A method of using the etching solution of the present embodiment will be described in detail in a method of forming a copper wiring described later.

The "copper" in the present embodiment may be made of copper or a copper alloy. In the present embodiment, "copper" refers to copper or a copper alloy.

The etching solution of the present embodiment is a copper etching solution, and contains an acid, an oxidizing metal ion, a bromide ion, a compound having a specific piperazine skeleton, and an imidazole compound.

### <Compound having a piperazine skeleton>

The etching solution of the present embodiment contains a compound having a piperazine skeleton as described below (hereinafter, it is also simply referred to as a piperazine compound) in order to suppress side etching without lowering the linearity of the copper wiring.

The piperazine compound of the present embodiment is a compound represented by the following general formula:

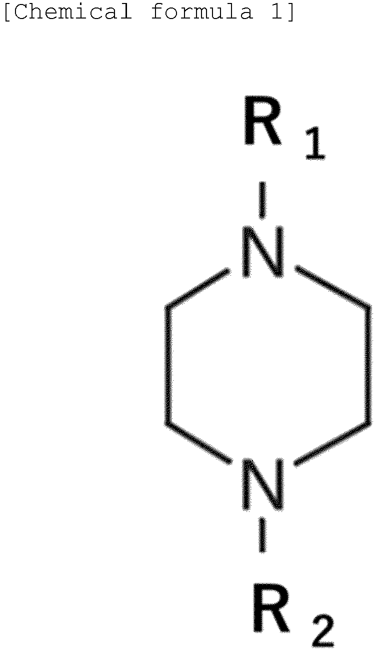

In the formula, R1 and R2 each independently represent a hydrogen atom, an amino group-containing substituent, or a hydrocarbon derivative group having 1 to 10 carbon atoms, wherein the hydrocarbon derivative group does not contain an amino group-containing substituent.

R1 and R2 may be the same as or different from each other.

The amino group is represented by any of -NH₂, -NHR, and -NRR', and R and R' each independently represent a hydrocarbon derivative group having 1 to 6 carbon atoms. The amino group-containing substituent refers to any of a substituent consisting of an amino group and a substituent in which one or more of the hydrogen atoms in a hydrocarbon derivative group having 1 to 6 carbon atoms is replaced by an amino group. Examples thereof include an aminoethyl group, an aminomethyl group, a diethylamino group, a dimethylamino group, a dimethylaminoethyl group, and a dimethylaminomethyl group.

The hydrocarbon derivative group refers to a hydrocarbon group having 1 to 10 carbon atoms. The hydrocarbon group is other than the amino group-containing substituent. One or more of the carbon atoms or one or more of the hydrogen atoms in the hydrocarbon group may be replaced by other atoms or substituents. Examples of the hydrocarbon derivative group include a methyl group, an ethyl group, a propyl group, an isopropyl group a butyl group, a sec-butyl group, an isobutyl group, a tert-butyl group, a hydroxymethyl group, a hydroxyethyl group, a hydroxypropyl group, a hydroxybutyl group, an allyl group, an acetyl group, a carboxy group, an aldehyde group, a carboxaldehyde group, a methoxy group, an ethoxy group, a propoxy group, a methoxymethyl group, a methoxyethyl group, a methoxypropyl group, a methoxybutyl group, an ethoxymethyl group, an ethoxyethyl group, an ethoxypropyl group, an ethoxybutyl group, a propoxymethyl group, a propoxyethyl group, a propoxypropyl group, a propoxybutyl group, a hydroxyethoxymethyl group, a hydroxyethoxyethyl group, a hydroxyethoxypropyl group, a hydroxyethoxybutyl group, a methoxycarbonyl group, a ethoxycarbonyl group, and a propoxycarbonyl group.

Examples of the piperazine compound of the present embodiment include piperazine, 1-methylpiperazine, 1-allylpiperazine, 1-isobutylpiperazine, 1-hydroxyethoxyethylpiperazine, 1-(2-aminoethyl)piperazine, 1-amino-4-methylpiperazine, 1-ethylpiperazine, 1-piperazineethanol, ethyl 1-piperazinecarboxylate, 1-formylpiperazine, 1-propylpiperazine, 1-acetylpiperazine, 1-isopropylpiperazine, 1-(2-methoxyethyl)piperazine, 1,4-dimethylpiperazine, 1-methyl-4'-(dimethylaminoethyl)piperazine, 1,4-bis(3-aminopropyl) piperazine, 1-(2-dimethylaminoethyl)-4-methylpiperazine, N-(2-aminoethyl)piperazine, 1-(2-hydroxyethyl) piperazine, N,N'-dimethylpiperazine, 1,4-bis(3-aminopropyl)piperazine, 1,4-diformylpiperazine, and the like.

The piperazine compound can be used alone or as a combination of two or more thereof.

Since the etching solution of the present embodiment contains the piperazine compound, the etching in the vertical direction in copper etching is performed more quickly, and at the same time, a more uniform protective film is easily formed. Therefore, it is possible to obtain an etching solution that more easily exhibits a function of suppressing excessive etching of the side surface of the copper wiring or the like (side etching).

Further, when the piperazine compound is allowed to coexist in the etching solution together with an imidazole compound described later, the piperazine compound is hardly decomposed, and the side etching suppression function can be maintained even when the etching solution is continuously used for a long time.

In the etching solution of the present embodiment, the content of the piperazine compound is, for example, 0.01 g/L or more and 100 g/L or less, or 0.02 g/L or more and 80 g/L or less, or 0.05 g/L or more and 30 g/L or less.

With such a content, it is possible to quickly progress copper etching in the vertical direction, and at the same time, it is possible to prepare an etching solution that easily forms a uniform protective film.

### <Imidazole compound>

The imidazole compound of the present embodiment has a function of suppressing decomposition of the piperazine compound by being present in the etching solution together with the piperazine compound.

The imidazole compound refers to a compound having an imidazole skeleton, and examples thereof include imidazole, 2-ethyl-4-methylimidazole, 1-imidazole acetic acid, 2-ethylimidazole, 2-aminobenzimidazole, 1-(3-aminopropyl)imidazole, 2-aminoimidazole sulfate, 2-methylimidazole, 2-undecyl-4-methylimidazole, 2-phenylimidazole, benzimidazole, 2-methylbenzimidazole, 2-undecylbenzimidazole, and 2-phenylbenzimidazole. When 2-aminoimidazole sulfate is used as the imidazole compound, the effect of suppressing the decomposition of the piperazine compound tends to be slightly reduced.

The imidazole compound can be used alone or as a combination of two or more thereof.

Since the etching solution of the present embodiment contains the imidazole compound, the etching solution acts on the compound having a piperazine skeleton, and can effectively suppress the decomposition thereof. In particular, as will be described later, even when an etching solution is used in a state in which a compound having a piperazine skeleton is easily decomposed, for example, by adding an oxidizing agent such as hydrogen peroxide in order to regenerate an oxidizing metal ion at the time of etching, decomposition of the piperazine compound can be effectively suppressed. Therefore, the side etching suppression function can be sufficiently maintained.

In addition, the imidazole compound effectively suppresses the decomposition of the piperazine compound, and at the same time, does not inhibit other performance characteristics of the etching solution, adjustment of the etching rate, uniform protective film formability, and the like. Therefore, the side etching suppression effect of the etching solution can be maintained without impairing the original etching performance.

The imidazole compound may be an imidazole compound having no amino group. When the imidazole compound is a compound having no amino group, in particular, the decomposition of the piperazine compound can be effectively suppressed, and the side etching suppression function can be sufficiently maintained.

Examples of the imidazole compound having no amino group include imidazole, 2-ethyl-4-methylimidazole, 1-imidazoleacetic acid, 2-ethylimidazole, 2-methylimidazole, 2-undecyl -4-methylimidazole, 2-phenylimidazole, benzimidazole, 2-methylbenzimidazole, 2-undecylbenzimidazole, and 2-phenylbenzimidazole.

In the etching solution of the present embodiment, the content of the imidazole compound is, for example, 0.10 g/L or more and 20 g/L or less, or 0.25 g/L or more and 20 g/L or less, or 0.5 g/L or more and 10 g/L or less, or 0.5 g/L or more and 5 g/L or less, or 0.6 g/L or more and 4 g/L or less.

Such a content makes it easy to suppress the decomposition of the piperazine compound, and in particular, even when an oxidizing agent or the like is added, an etching solution capable of sufficiently suppressing the decomposition of the piperazine compound can be prepared.

### <Acid>

The acid used in the etching solution of the present embodiment can be appropriately selected from an inorganic acid and an organic acid. Examples of the inorganic acid include sulfuric acid, hydrochloric acid, nitric acid, phosphoric acid, and hydrobromic acid. Examples of the organic acid include formic acid, acetic acid, oxalic acid, maleic acid, benzoic acid, and glycolic acid. Among the acids, hydrochloric acid is preferable from the viewpoint of the stability of the etching rate and the dissolution stability of copper.

The concentration of the acid in the etching solution of the present embodiment is, for example, 5 g/L or more and 350 g/L or less, or 5 g/L or more and 330 g/L or less, or 10 g/L or more and 350 g/L or less, or 20 g/L or more and 330 g/L or less, or 5 g/L or more and 180 g/L or less, or 7 g/L or more and 150 g/L or less. When the concentration of the acid is in the above range, the etching rate can be easily adjusted appropriately, copper can be etched at an appropriate rate, the dissolution stability of copper is maintained, and deterioration of the working environment can be suppressed.

The acids can be used alone or as a combination of two or more thereof.

### <Oxidizing metal ion>

The oxidizing metal ion used in the etching solution of the present invention may be a metal ion capable of oxidizing metallic copper, and examples thereof include a cupric ion and a ferric ion. From the viewpoint of suppressing the side etching and the viewpoint of the stability of the etching rate, it is preferable to use a cupric ion as the oxidizing metal ion.

The oxidizing metal ion can be contained in the etching solution by blending an oxidizing metal ion source. For example, when a cupric ion source is used as the oxidizing metal ion source, examples thereof include copper chloride, copper sulfate, copper bromide, a copper salt of the organic acid, and copper hydroxide. For example, when a ferric ion source is used as the oxidizing metal ion source, specific examples thereof include iron chloride, iron bromide, iron iodide, iron sulfate, iron nitrate, and an iron salt of the organic acid.

The oxidizing metal ions can be used alone or as a combination of two or more thereof as necessary.

The concentration of the oxidizing metal ion in the etching solution of the present embodiment is, for example, 10 g/L or more and 300 g/L or less, or 10 g/L or more and 250 g/L or less, or 15 g/L or more and 220 g/L or less, or 30 g/L or more and 200 g/L or less. When the concentration of the oxidizing metal ions is in the above range, the etching rate is easily adjusted appropriately, copper can be etched at an appropriate rate, and the dissolution stability of copper is maintained.

### <Bromide ion>

The bromide ion used in the etching solution of the present embodiment can be contained in the etching solution by blending a bromide ion source. Examples thereof include hydrobromic acid, sodium bromide, potassium bromide, lithium bromide, magnesium bromide, calcium bromide, barium bromide, copper bromide, zinc bromide, ammonium bromide, silver bromide, and bromine. Hydrobromic acid, sodium bromide, and potassium bromide are preferable from the viewpoint of further suppressing the decrease in the linearity of the copper wiring and the side etching, and further suppressing the variation in the wiring width (W1) of the bottom part of the copper wiring after the etching.

The bromide ion source can be used alone or as a combination of two or more thereof as necessary.

The concentration of the bromide ion in the etching solution of the present embodiment is, for example, 10 g/L or more and 150 g/L or less, or 20 g/L or more and 120 g/L or less, or 30 g/L or more and 110 g/L or less. When the concentration of the bromide ion is in the above range, side etching can be effectively suppressed, and at the same time, variation in the wiring width (W1) of the copper wiring bottom part after etching can be effectively suppressed.

In addition to the above-described components, other components may be added to the etching solution of the present embodiment to such an extent that the effect of the present invention is not hindered. For example, a surfactant, a component stabilizer, an antifoaming agent, or the like may be added. When the other component is added, the concentration thereof in the etching solution of the present embodiment is about 0.001 g/L or more and 5 g/L or less.

The etching solution can be easily prepared by dissolving the respective components in water. As the water, water from which an ionic substance and impurities have been removed is preferable, and for example, ion-exchanged water, pure water, ultrapure water, or the like is preferable.

In the etching solution, each component may be blended so as to have a predetermined concentration at the time of use, or a concentrated solution may be prepared and diluted immediately before use. A method of using the etching solution is not particularly limited, but in order to effectively suppress side etching, it is preferable to perform etching using a spray as described later. In addition, the temperature of the etching solution at the time of use is not particularly limited, but it is preferable to use the etching solution at 20°C or more and 60°C or less in order to effectively suppress side etching while maintaining high productivity.

Next, the replenishment solution of the present embodiment will be described.

The replenishment solution of the present embodiment is a replenishment solution to be added to the etching solution when the etching solution of the present embodiment is continuously or repeatedly used, and is a replenishment solution containing the compound having a piperazine skeleton and the imidazole compound.

The components in the replenishment solution are the same as the components that can be blended in the etching solution of the present embodiment described above. By adding the replenishment solution, the respective component ratios of the etching solution are appropriately maintained, so that the effect of the etching solution of the present embodiment described above can be stably maintained.

In the replenishment solution of the present embodiment, the acid contained in the etching solution may be contained in a range not exceeding a concentration of 360 g/L. The replenishment solution may contain each oxidizing metal ion contained in the etching solution within a range not exceeding a concentration of 14 g/L. The replenishment solution may contain a bromide ion source contained in the etching solution described above within a range not exceeding a concentration of 800 g/L in terms of bromide ion concentration. In addition to the above components, a component to be added to the etching solution may be blended in the replenishment solution. The components that may be contained in the replenishment solution may be directly added to the etching solution when the etching solution is continuously or repeatedly used without being contained in the replenishment solution.

The concentration of each component in the replenishment solution is appropriately set according to the concentration of each component in the etching solution, and from the viewpoint of stably maintaining the effect of the etching solution of the present embodiment described above, the concentration of the compound having a piperazine skeleton is preferably 0.01 g/L or more and 800 g/L or less. Similarly, the concentration of the imidazole compound is preferably 0.1 g/L or more and 400 g/L or less.

Next, a method for forming a copper wiring of the present embodiment will be described.

A method for forming a copper wiring (Hereinafter, the method is also simply referred to as a method.) according to the present embodiment is a method for forming a copper wiring by etching a copper layer not covered with an etching resist, and etching is performed using the etching solution according to the present embodiment described above.

The copper wiring in the present embodiment mainly refers to a copper wiring formed by a photoetching method in the manufacture of a printed wiring board.

Examples of a method for forming such a copper wiring include forming an etching resist on a copper layer such as a copper foil on an insulating base material, an electroless copper plated film, an electroplating copper film, or a copper sputtered film, and etching copper in a part not covered with the etching resist to form a wiring pattern.

Examples of the printed wiring board having copper wiring include a rigid substrate, a flexible substrate, a metal core substrate, and a ceramic substrate.

The etching resist is not particularly limited, and examples thereof include those made of an insulating resin such as a dry film and a liquid resist, and those made of one or more layers of metal such as nickel and nickel/gold.

The method for forming a copper wiring of the present embodiment is suitable for forming a copper wiring having a fine wiring pattern.

In a case where the pattern is fine, it is necessary to reduce side etching as much as possible, and in the method for forming a copper wiring using the etching solution of the present embodiment, there is an advantage that occurrence of side etching can be effectively suppressed even if continuous etching is performed.

In the method of the present embodiment, it is preferable to spray an etching solution onto the copper layer by spraying to perform etching. This is because side etching can be effectively suppressed. The spray nozzle is not particularly limited, and any nozzle such as a fan-shaped nozzle, a full cone nozzle, or a two-fluid nozzle can be used. In addition, the spray pressure in the case of etching by spray is, for example, 0.04 MPa or more, 0.08 MPa or more, or 0.1 MPa or more. When the spray pressure is equal to or higher than the above pressure, the protective film can be formed on the side surface of the copper wiring with an appropriate thickness. Thereby, side etching can be effectively prevented. The spray pressure is for example, 0.30 MPa or less from the viewpoint of preventing breakage of the etching resist.

The etching solution of the present embodiment used in the method for forming a copper wiring of the present embodiment can maintain an action of suppressing side etching.

A mechanism for suppressing side etching is considered as follows. When copper wiring is formed by an etching solution containing an oxidizing metal ion source such as copper chloride as in the etching solution of the present embodiment, a cuprous ion and a salt thereof are generated with the progress of etching. Since the solution exchange between the wirings is delayed, particularly in the fine wirings, the etching in the vertical direction gradually hardly proceeds due to the influence of a cuprous ion and a salt thereof, and as a result, the side etching becomes large.

In the etching solution of the present embodiment, since a compound having a piperazine skeleton and a bromide ion are contained, a cuprous ion and a salt thereof generated with the progress of etching can be captured by the compound having a piperazine skeleton. As a result, it is considered that the etching in the vertical direction is rapidly progressed, and at the same time, a protective film composed of a cuprous ion, a salt thereof, the compound having a piperazine skeleton, and a bromide ion is formed on the side surface of the copper wiring which is hardly directly subjected to the impact of the spray, and the side etching can be suppressed by the protective film.

On the other hand, a compound having a piperazine skeleton may be decomposed by continuously using an etching solution.

For example, in the method for forming a copper wiring according to the present embodiment, an oxidizing agent such as hydrogen peroxide or chlorate may be added to the etching solution. By adding such an oxidizing agent, the etching solution can be regenerated. That is, as described above, the number of the cuprous ions increases and the etching performance is deteriorated, but the etching performance can be prevented from being deteriorated by regenerating the cuprous ion to the cupric ion by the addition of the oxidizing agent. In this case, since the added oxidizing agent also has an action of decomposing the compound having a piperazine skeleton, the function of suppressing side etching may be deteriorated.

However, since the etching solution of the present embodiment contains an imidazole compound together with the compound having a piperazine skeleton, the concentration of the compound having a piperazine skeleton can be maintained in a predetermined range even in a case where etching is continuously performed or the liquid is regenerated by adding the oxidizing agent.

Therefore, even when etching is continuously performed, the function of suppressing side etching can be stably maintained.

In addition, in the method for forming a copper wiring according to the present embodiment, when etching is continuously performed, the replenishment solution of the present embodiment described above may be supplied in a timely manner in order to maintain predetermined etching performance.

In this case, the timing of supplying the replenishment solution can be appropriately set, for example, by monitoring an arbitrary component concentration in the etching solution and supplying the replenishment solution when the concentration exceeds or falls below a predetermined concentration range, or supplying the replenishment solution by a change in a formed wiring shape or the like.

In the method for forming a copper wiring of the present embodiment, steps such as cleaning of copper to be etched before and after etching, pretreatment before providing an etching resist on the copper surface, and peeling of the etching resist can be appropriately performed.

The etching solution, the replenishment solution, and the method for forming the copper wiring according to the present embodiment are as described above, but it should be considered that the embodiment disclosed herein is an example in all respects and is not restrictive. The scope of the present invention is indicated not by the above description but by the claims, and it is intended that meanings equivalent to the claims and all modifications within the scope are included.

Expressions such as "including", "comprising", "have", "is" used to describe and claim the present embodiment are intended to be construed in a non-exclusive manner, namely allowing for items, components or elements not explicitly described also to be present. Reference to the singular is also to be construed to relate to the plural.

### Examples

Hereinafter, the present invention will be described more specifically with reference to examples, but the present invention is not limited to these examples.

### [Test 1: Component remaining test]

### (Etching solution)

Each etching solution used in this example was prepared.

Each etching solution was prepared using each material shown below. It was obtained as an aqueous solution mixed with the following: 440 g/L of cupric chloride dihydrate (copper ion concentration: 161 g/L), 130 g/L of 47% hydrobromic acid (bromide ion concentration: 60 g/L), 263 g/L of 35% hydrochloric acid (acid concentration: 92 g/L), 2 g/L of a compound having a piperazine skeleton, 1 g/L of an imidazole compound or a tetrazole compound (or an imidazole compound or a tetrazole compound is not added), and residual ion-exchanged water.

The concentration of the imidazole compound was partially changed. For the material in which the concentration was changed, the concentration was described in the table.

### Materials

Cupric chloride dihydrate: manufactured by Nihon Kagaku Sangyo Co., Ltd.
47% hydrobromic acid: manufactured by Tosoh Corporation
35% hydrochloric acid: manufactured by Toagosei Co., Ltd.

### Compound having piperazine skeleton

·1-methyl-4'-(dimethylaminoethyl)piperazine: manufactured by Tokyo Chemical Industry Co., Ltd.
·N-(2-aminoethyl)piperazine: manufactured by Tokyo Chemical Industry Co., Ltd.
·1-(2-Hydroxyethyl)piperazine: manufactured by Tokyo Chemical Industry Co., Ltd.
·N,N'-dimethylpiperazine: manufactured by Tokyo Chemical Industry Co., Ltd.

### Imidazole compound

·2-ethyl-4-methylimidazole: manufactured by Tokyo Chemical Industry Co., Ltd.
·Imidazole: manufactured by Tokyo Chemical Industry Co., Ltd.
·1-Imidazoleacetic acid: manufactured by Tokyo Chemical Industry Co., Ltd.
·2-Ethylimidazole: manufactured by Tokyo Chemical Industry Co., Ltd.
·2-Aminobenzimidazole: manufactured by Tokyo Chemical Industry Co., Ltd.
·1-(3-aminopropyl)imidazole: manufactured by Tokyo Chemical Industry Co., Ltd.
·2-Aminoimidazole sulfate: manufactured by Tokyo Chemical Industry Co., Ltd.

### Tetrazole compound

·1H-Tetrazole: manufactured by Tokyo Chemical Industry Co., Ltd.
·5-Aminotetrazole: manufactured by Tokyo Chemical Industry Co., Ltd.
35% aqueous hydrogen peroxide: manufactured by ADEKA CORPORATION

The concentration of each the compound having a piperazine skeleton in each prepared solution was measured using a high performance liquid chromatography (HPLC, e2695 manufactured by Waters Corporation) apparatus.

Thereafter, 2 ml of 35% hydrogen peroxide was added to 1 L of each etching solution, mixed, and then left at room temperature for 24 hours, and the concentration of each compound having a piperazine skeleton was measured again using an HPLC apparatus under the same conditions. The results in which the concentration of the compound having a piperazine skeleton after the addition of hydrogen peroxide relative to that before the addition of hydrogen peroxide is expressed in % are shown in Table 1 as the residual ratio (%).

**[Table 1]**

| Compound having piperazine skeleton | Imidazole compound/Tetrazole compound | Residual ratio (%) |
|---|---|---|
| | 2-Ethyl-4-methylimidazole | 99.8 |
| | Imidazole | 100.0 |
| | Imidazole (0.1) | 62.0 |
| | Imidazole (0.25) | 91.5 |
| | Imidazole (0.5) | 99.3 |
| | 1-Imidazole acetic acid | 88.5 |
| 1-methyl-4'-(dimethylaminoethyl)piperazine | 2-ethylimidazole | 76.9 |
| | 2-Aminobenzimidazole | 65.1 |
| | 2-Aminoimidazole sulfate | 28.6 |
| | 1H-Tetrazole | 0.0 |
| | 5-Aminotetrazole | 0.0 |
| | None | 0.0 |
| N-(2-aminoethyl)piperazine | 2-Ethyl-4-methylimidazole | 99.0 |
| | 2-Ethyl-4-methylimidazole (0.1) | 60.5 |
| | 2-Ethyl-4-methylimidazole (0.25) | 87.2 |
| | 2-Ethyl-4-methylimidazole (0.5) | 98.2 |
| | Imidazole | 100.0 |
| | 1-(3-Aminopropyl)imidazole | 50.9 |
| | 1H-Tetrazole | 18.2 |
| | None | 24.1 |
| 1-(2-Hydroxyethyl)piperazine | Imidazole | 93.3 |
| | 1-Imidazole acetic acid | 91.4 |
| | 2-Aminoimidazole sulfate | 78.4 |
| | None | 74.1 |
| N,N'-dimethylpiperazine | 2-Ethyl-4-methylimidazole | 92.8 |
| | 2-ethylimidazole | 93.7 |
| | 2-Aminobenzimidazole | 84.3 |
| | 1H-Tetrazole | 72.1 |
| | None | 58.9 |

### [Test 2: Observation of pattern shape]

### (Substrate)

A copper-clad laminate on which an electrolytic copper foil (Manufactured by Mitsui Mining & Smelting Corporation, trade name 3EC-III) having a thickness of 12 µm was laminated was prepared, and the copper foil was treated with a palladium catalyst-containing treatment solution (manufactured by OKUNO Chemical Industries Co., Ltd., trade name: ADDCOPPER series), and then an electroless copper plated film was formed using an electroless copper plating solution (manufactured by OKUNO Chemical Industries Co., Ltd. trade name: ADDCOPPER series). Next, an electroplating copper film having a thickness of 10 µm was formed on the electroless copper plated film using an electrolytic copper plating solution (Manufactured by OKUNO Chemical Industries Co., Ltd., trade name: TOP LUCINA SF), and the total thickness of the copper layer was set to 22.5 µm. The surface of the obtained electrolytic copper plated film was coated with a dry film resist having a thickness of 25 µm. Thereafter, the dry film was exposed using a glass mask of line/space (L/S) =36 µm/24 µm, and an unexposed part was removed by development processing to produce an etching resist pattern of L/S=36 µm/24 µm.

A test for etching the substrate was performed using one of the etching solutions prepared in the above Test 1. The etching solution was prepared using 1-methyl-4'-(dimethylaminoethyl)piperazine as a compound having a piperazine skeleton and using a compound described in Table 2 as an imidazole compound or a tetrazole compound. 35% hydrogen peroxide was added and mixed into the solution, and then the resulting mixture was allowed to stand at room temperature for 24 hours. Etching was performed by spraying at a spray pressure of 0.20 MPa and a liquid temperature of 45°C for 138 seconds using a fan-shaped nozzle (Product name: ISVV9020, manufactured by H. IKEUCHI & CO., LTD.). The treatment time was set to 138 seconds for the following method. It is set to a time point at which the wiring width of the copper wiring bottom part after etching reaches 30 µm when etching is performed with an etching solution using imidazole as an imidazole compound of a material of the etching solution, in which the residual ratio of the compound having a piperazine skeleton is 100.0%.

Thereafter, each treatment of water washing, dry film resist peeling (immersion in acetone for 30 seconds), and drying was performed to prepare a copper pattern-formed substrate.

Thereafter, each substrate was cut, embedded in a polyester cold mounting resin, polished, and the cross section was observed with a metal microscope (VHX-7000 manufactured by KEYENCE CORPORATION) at a magnification of 1000. Length measurement was performed at five points on each of the copper wiring top part and the copper wiring bottom part, and the average was defined as a top width (T) and a bottom width (B).

The results are shown in Table 2.

**[Table 2]**

| Imidazole compound/Tetrazole compound | Imidazole | 2-Aminobenzimidazole | 1H-Tetrazole |
|---|---|---|---|
| Residual ratio (%) | 100.0 | 65.1 | 0.0 |
| Treatment time (second) | 138 | 138 | 138 |
| Top width T/Bottom width B (µm) | 24.3/32.6 | 18.7/19.4 | 15.9/14.5 |

### [Test 3: Pattern shape change due to change in imidazole compound concentration]

Among the etching solutions prepared in the above Test 1, two kinds of etching solutions including a combination of 1-methyl-4'-(dimethylaminoethyl) piperazine and imidazole, and a combination of N-(2-aminoethyl) piperazine and 2-ethyl-4-methylimidazole as a compound having a piperazine skeleton and an imidazole compound were prepared. The concentration of the imidazole compound in the etching solutions was changed to the concentration described in Table 3. A pattern was formed by the same method as in the above Test 2, except that the treatment time was changed to the number of seconds described in Table 3 and 5% hydrogen peroxide was not added. The bottom width (B) of the pattern was measured in the same manner as in Test 2. The results are shown in Table 3.

**[Table 3]**

| Piperazine compound | Imidazole compound | Imidazole compound concentration (g/L) | Number of seconds of treatment | Number of seconds of treatment (µm) | Bottom width B (µm) |
|---|---|---|---|---|---|
| | | 1 | 132s | 26.6 | 41.8 |
| | | 1 | 138s | 25.3 | 31.9 |
| | | 1 | 144s | 23.6 | 26.5 |
| 1-Methyl-4'-(dimethylaminoethyl) piperazine | Imidazole | 4 | 132s | 26.9 | 38.3 |
| | | 4 | 138s | 25.5 | 31.6 |
| | | 4 | 150s | 21.8 | 27.1 |
| | | 30 | 114s | 20.7 | 23.7 |
| | | 30 | 118s | 27.8 | 43.6 |
| | | 30 | 120s | 21.3 | 26.0 |
| | | 1 | 132s | 25.6 | 37.5 |
| | | 1 | 138s | 21.9 | 27.3 |
| | | 1 | 144s | 20.3 | 23.4 |
| N-(2-aminoethyl) piperazine | 2-ethyl-4-methylimidazole | 4 | 132s | 25.9 | 33.8 |
| | | 4 | 138s | 25.9 | 32.9 |
| | | 4 | 144s | 21.4 | 22.8 |
| | | 30 | 132s | 20.6 | 31.2 |
| | | 30 | 138s | 17.8 | 22.6 |
| | | 30 | 144s | 23.7 | 25.6 |

### [Test 4: Component remaining test by change in piperazine compound concentration]

In the same etching solution as in Test 1, in which the concentration of the compound having a piperazine skeleton was changed, the concentrations of the compound having a piperazine skeleton and the imidazole compound after addition of hydrogen peroxide were measured by the same method as in Test 1. N-(2-aminoethyl) piperazine was used as a compound having a piperazine skeleton, and imidazole was used as an imidazole compound. The results are shown in Table 4.

**[Table 4]**

| N-(2-aminoethyl)piperazine | | Imidazole | |
|---|---|---|---|
| Amount added (g/L) | Residual ratio (%) after addition of hydrogen peroxide | Amount added (g/L) | Residual ratio (%) after addition of hydrogen peroxide |
| 0.1 | 100.0 | 1.0 | 38.3 |
| 0.2 | 98.4 | 1.0 | 38.1 |
| 0.4 | 100.0 | 1.0 | 38.5 |
| 2.0 | 100.0 | 1.0 | 39.5 |
| 20.0 | 92.3 | 1.0 | 51.7 |

### [Discussion]

For Test 1, it was apparent that each etching solution containing an imidazole compound had a higher residual ratio of the compound having a piperazine skeleton as compared with an etching solution containing a tetrazole compound and an etching solution containing no imidazole compound or tetrazole compound.

In Test 2, when the residual ratio of the compound having a piperazine skeleton was low, the pattern shape after etching was thin in both the top width (T) and the bottom width (B).

That is, it was clear that the effect of suppressing excessive etching of the side surface of the wiring by the compound having a piperazine skeleton is easily maintained by blending the imidazole compound.

In Test 3, when the imidazole compound concentration is 1 g/L and 4 g/L, the bottom width of the pattern becomes narrower as the treatment time becomes longer in any etching solution. That is, it is possible to easily set an appropriate treatment time for obtaining a desired pattern width. When the imidazole compound concentration is 30 g/L, there is no correlation between the treatment time and the bottom width, and thus it is found that it is slightly difficult to set an appropriate treatment time for obtaining a desired pattern width.

In Test 4, even when the concentration of the compound having a piperazine skeleton was any concentration of 0.1 to 20 g/L, the residual ratio of the compound having a piperazine skeleton was very high even after the addition of hydrogen peroxide because 1 g/L of the imidazole compound was contained. That is, it has become clear that when a compound having a piperazine skeleton is contained in the above concentration range, the effect of suppressing excessive etching of the side surface of the wiring at an imidazole compound concentration of 1 g/L can be maintained.

## Claims

1. A etching solution for copper comprising: an acid; an oxidizing metal ion; a bromide ion; a compound having a piperazine skeleton; and an imidazole compound, **characterized in that**
the compound having a piperazine skeleton is represented by the following general formula (1): 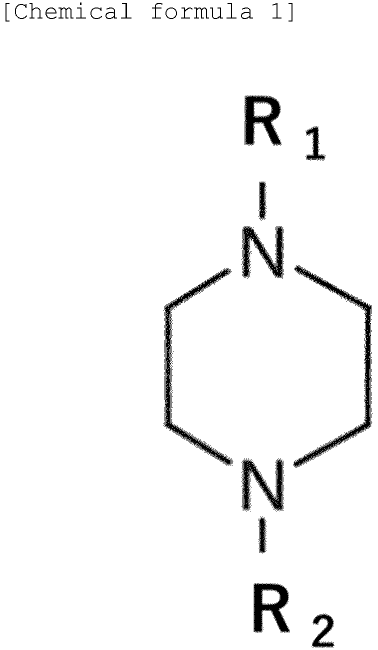
wherein R1 and R2 each independently represent a hydrogen atom, an amino group-containing substituent, or a hydrocarbon derivative group having 1 to 10 carbon atoms wherein the hydrocarbon derivative group does not contain an amino group-containing substituent.

2. The etching solution according to claim 1, **characterized in that** the imidazole compound is one or more selected from the group consisting of imidazole, 2-ethyl-4-methylimidazole, 1-imidazole acetic acid, 2-ethylimidazole, 2-aminobenzimidazole, 1-(3-aminopropyl)imidazole, and 2-aminoimidazole sulfate.

3. The etching solution according to claim 1, **characterized in that** the imidazole compound is an imidazole compound having no amino group.

4. The etching solution according to claim 2, **characterized in that** the imidazole compound is an imidazole compound having no amino group.

5. The etching solution according to any one of claims 1 to 4, **characterized in that** the imidazole compound is contained in an amount of 0.10 g/L or more and 20 g/L or less.

6. The etching solution according to any one of claims 1 to 4, **characterized in that** the compound having a piperazine skeleton is contained in an amount of 0.01 g/L or more and 100 g/L or less.

7. The etching solution according to any one of claims 1 to 4, **characterized in that** the acid is hydrochloric acid.

8. The etching solution according to any one of claims 1 to 4, **characterized in that** the oxidizing metal ion is a cupric ion.

9. The etching solution according to any one of claims 1 to 4, **characterized in that** a concentration of the bromide ion is 10 g/L or more and 150 g/L or less.

10. A replenishment solution to be added to the etching solution when the etching solution according to any one of claims 1 to 4 is continuously or repeatedly used, the replenishment solution comprising:
the compound having a piperazine skeleton; and the imidazole compound.

11. A method for forming a copper wiring by etching a copper layer not covered with an etching resist, the etching is performed using the etching solution according to any one of claims 1 to 4.
